# EUROPÄISCHE PATENTSCHRIFT

(11) **EP 0 682 321 B1**
(45) Veröffentlichungstag und Bekanntmachung des Hinweises auf die Patenterteilung: **02.04.2003**
(21) Anmeldenummer: 95107090.3
(22) Anmeldetag: 10.05.1995
(51) Int. Cl.: G06K 19/077

(54) **Datenträger mit integriertem Schaltkreis und Verfahren zur Herstellung eines Datenträgers**
Record carrier with integrated circuit and procedure for manufacturing a record carrier
Porteur d'information à puce et procédé de préparation d'un porteur d'information

(30) Priorität: 11.05.1994 DE 4416697
(43) Veröffentlichungstag der Anmeldung: 15.11.1995
(60) Teilanmeldung: 02021127.2
(73) Patentinhaber: Giesecke & Devrient GmbH, 81677 München (DE)
(72) Erfinder: Haghiri-Tehrani, Yahya, D-80797 München (DE)
(74) Vertreter: Klunker . Schmitt-Nilson . Hirsch

(56) Entgegenhaltungen:
- EP-A- 0 570 062
- WO-A-88/08592
- DE-A- 4 105 869

## Beschreibung

Die Erfindung betrifft einen Datenträger gemäß dem Oberbegriff des Anspruchs 1. Ferner betrifft die Erfindung ein Verfahren zur Herstellung eines Datenträgers.

Datenträger mit integrierten Schaltkreisen werden in Form von Kreditkarten, Bankkarten, Barzahlungskarten und dergleichen in den verschiedensten Dienstleistungssektoren, beispielsweise im bargeldlosen Zahlungsverkehr oder im innerbetrieblichen Bereich, als Zugangsberechtigung eingesetzt. Bei einem Großteil dieser Datenträger erfolgt die Energieversorgung und/oder der Datenaustausch mit externen Geräten berührend über die äußeren Kontaktflächen eines elektronischen Moduls. Da bei diesen Datenträgern nach dem Stand der Technik die Kontaktflächen zum Anschluß der Datenträger an eine Lese/Schreibeinrichtung freiliegen, besteht die Gefahr einer Verschmutzung der Kontaktflächen, wodurch in Folge einer schlechten Kontaktierung eine fehlerhafte Datenübertragung zwischen dem Datenträger und der betreffenden Lese/Schreibeinrichtung des Terminals auftreten kann. Unabhängig davon kann eine fehlerhafte Datenübertragung auch aufgrund einer fehlerhaften Positionierung der Kontaktflächen in der Lese-/Schreibeinrichtung des Terminals auftreten. Zur Vermeidung der o.g. Nachteile sind aus dem Stand der Technik bereits Datenträger mit kontaktloser, z. B. induktiver Kopplung, bekannt.

Aus der EP-A1 0 376 062 ist z. B. ein elektronisches Modul und ein Verfahren zur Herstellung des Moduls bekannt. Das bekannte Modul beinhaltet einen isolierenden Trägerfilm, einen Chip mit integriertem Schaltkreis, der wenigstens zwei Verbindungsanschlüsse aufweist und auf dem Trägerfilm angeordnet ist. Auf der gleichen Seite des Trägerfilms des Moduls ist eine Spule angeordnet. Die Spule, welche Bestandteil des Moduls ist, ermöglicht hierbei die induktive Kopplung zwischen dem Modul und einem externen Gerät. Die Spule ist als ringförmige, drahtgewickelte Spule ausgeführt, die einen Raum umgibt, in dem der Chip und die die Anschlüsse des Chips mit den Anschlüssen der Spule elektrisch leitend verbindenden Elemente komplett untergebracht sind und der anschließend mit einer elektrisch isolierenden und gehärteten klebenden Masse gefüllt ist. Das bekannte Modul wird nach seiner Fertigstellung dann in eine Karte eingebaut, wobei die Spule einen wirksamen Schutz des Chips und der elektrisch leitenden Verbindungselemente gegen Spannungen, denen diese Karte beim Gebrauch ausgesetzt ist, gewährleistet.

Aus der DE 4 105 869 A1 bzw. der WO 88/08592 ist es ebenfalls bekannt, ein Modul vorzusehen, bei dem auf einer Trägerfolie ein integrierten Schalkreis sowie Koppelelemente angeordnet sind.

Durch die Anordnung der Spule auf dem Modul ist zwar einerseits ein guter Schutz für den Chip erreicht, andererseits bringt es dieser spezielle Aufbau eines Moduls mit sich, daß zur Herstellung eines Datenträgers mit kontaktloser Kopplung speziell aufgebaute Module verwendet werden müssen. Dies hat den Nachteil, daß zur Fertigung der Module ein spezielles Verfahren benötigt wird bzw. spezielle Werkzeuge bereitgestellt werden müssen. Darüber hinaus können bedingt durch die spezielle Fertigung dieser Module herkömmliche, d. h. Module ohne Spule für die Herstellung eines Datenträgers mit kontaktloser Kopplung nicht verwendet werden. Schließlich können bei kleinen Auflagen von Datenträgern mit kontaktloser Kopplung mit einem speziell hergestellten Modul hohe Kosten entstehen, da dieses gesondert gefertigt werden muß. Dies alles bedeutet, daß durch diese speziellen Module die Flexibilität bei der Herstellung von Datenträgern mit kontaktloser Kopplung beeinträchtigt ist.

Der Erfindung liegt somit die Aufgabe zugrunde, einen Datenträger mit kontaktloser Kopplung vorzuschlagen, der einfacher herstellbar ist.

Die Aufgabe wird durch die in dem unabhängigen Patentanspruch 1 angegebenen Merkmal und durch das verfahren des unabhängigen verfahrenanspruchs 7 gelöst.

Der Grundgedanke der Erfindung besteht in der Entkopplung von Modul und Spule, wobei das Modul in an sich bekannter Weise separat hergestellt werden kann und die Spule unabhängig von dem Modul gefertigt und auf einer Schicht des Kartenkörpers aufgebracht wird.

Die Spule kann beispielsweise auf einer Deckschicht oder auf einer inneren Schicht eines mehrschichtig aufgebauten Kartenkörpers oder auf einem spritzgegossenen Kartenkörperteil angeordnet werden. Die Spule kann z. B. drahtgewickelt oder auch als elektrisch leitende Schicht im Siebdruckverfahren z. B. mittels eines elektrisch leitenden Klebers auf die Kartenkörperschicht aufgedruckt werden. Die Spule kann auch alternativ aus einer Metallfolie gestanzt oder aus einer elektrisch leitend beschichteten Kunststoffolie geätzt und auf die Kartenkörperschicht aufgeklebt werden. Weiter ist es auch möglich, daß die Spule in Form einer elektrisch leitenden Schicht im Heißprägeverfahren in die Kartenkörperschicht geprägt wird. Vorzugsweise ist die Spule als Flachspule ausgebildet, wobei die Anschlüsse der Spule und die Kontaktelemente des Moduls bezüglich der Lage und Position im Kartenkörper in bezug aufeinander normiert sind, beispielsweise einander direkt gegenüber angeordnet sind, wodurch eine einfache elektrisch leitende Verbindung zwischen den Anschlüssen der Spule und denen des Moduls hergestellt werden kann. Dies kann beispielsweise mit Hilfe eines elektrisch leitenden Klebers oder auch mittels Löten oder anderer gängiger Techniken, die dem Fachmann bekannt sind, erfolgen. Abschließend sei bemerkt, daß das Modul auch als Hybridmodul ausgeführt sein kann, das zusätzlich äußere Kontaktflächen zur berührenden Kopplung mit externen Geräten aufweist.

Die mit der Erfindung erzielten Vorteile bestehen insbesondere darin, daß die in herkömmlicher Weise hergestellten Module, d. h. Module ohne Spulen, verwendbar sind, wodurch die Herstellung von Datenträgern mit kontaktloser Kopplung flexibler gestaltet werden kann. Dadurch ist keine nennenswerte Änderung bei der bisherigen Modulherstellung notwendig, so daß keine speziellen neuen Werkzeuge und auch kein neues Verfahren zur Herstellung der Module benötigt wird. Darüber hinaus ermöglicht die Erfindung aufgrund der Anordnung der Spule auf einer Kartenkörperschicht auch eine hohe Flexibilität bei der Auslegung der Spule, beispielsweise hinsichtlich der benötigten Induktivität, z. B. bei der Windungszahl, bei der aktiven Spulenfläche bzw. dem Drahtdurchmesser etc. und auch eine hohe Flexibilität bei der Auswahl der Technik, in der die Spule auf der Kartenkörperschicht realisiert wird. Darüber hinaus ermöglicht die Erfindung eine einfache Verbindung des Moduls mit der Spule, insbesondere dann, wenn die Spulenanschlüsse und die Kontaktelemente des Moduls, die mit den Spulenanschlüssen elektrisch verbunden werden, hinsichtlich der Lage und Position im Kartenkörper standardisiert sind. Auch kann der Aufbau des Moduls bis auf die Lage und Position der Kontaktelemente frei gewählt werden, so können beispielsweise die Kontaktelemente des Moduls aus einem elektrisch leitend beschichteten Trägerfilm oder in der Leadframe-Technik aus einem Metallband durch entsprechendes Stanzen erhalten werden. Der integrierte Schaltkreis kann hierbei z. B. mit Hilfe eines Klebers auf einem zentralen Bereich des gestanzten Leiterrahmens aufgeklebt werden. Die elektrisch leitende Verbindung des integrierten Schaltkreises mit den Kontaktelementen des Moduls kann z. B. in bekannter Weise per wire-bondingoder in der sogenannten TAB-Technik erfolgen. Diese Techniken und die in diesem Zusammenhang unterschiedlichen Ausgestaltungen der Module sind dem Fachmann geläufig. Weitere Eigenschaften und Vorteile der Erfindung ergeben sich aus der nachfolgenden Beschreibung verschiedener Ausführungsbeispiele, die anhand der Zeichnungen näher erläutert sind.

Weitere Ausführungsformen und Vorteile der Erfindung ergeben sich aus den Unteransprüchen sowie den Zeichnungen. Darin zeigen:
- Fig. 1: ein Ausfürhungsbeispiel eines Datenträgers in der Aufsicht, wobei das Modul und ein Teil der Spule als Ausschnitt ohne obere Deckschicht dargestellt sind,
- Fig. 2: den Ausschnitt des Datenträgers gemäß Fig. 1 in einer Schnittdarstellung,
- Fig. 3: die Aufsicht auf ein weiteres Ausführungsbeispiel eines Datenträgers, wobei das Modul und ein Teil der Spule als Ausschnitt dargestellt sind,
- Fig. 4: den Ausschnitt des Datenträgers gemäß Fig. 3 in einer Schnittdarstellung,
- Fig. 5: ein weiteres Ausführungsbeispiel mit spritzgegossenem Kartenkörperteil,
- Fig. 6: eine Spritzgußform mit eingelegtem Karteninlett,
- Fig. 7: ein Hybridmodul und einen Kartenkörperteil mit Spule,
- Fig. 8: ein kontaktloses Modul mit zugehörigem Kartenkörperteil und Spule.

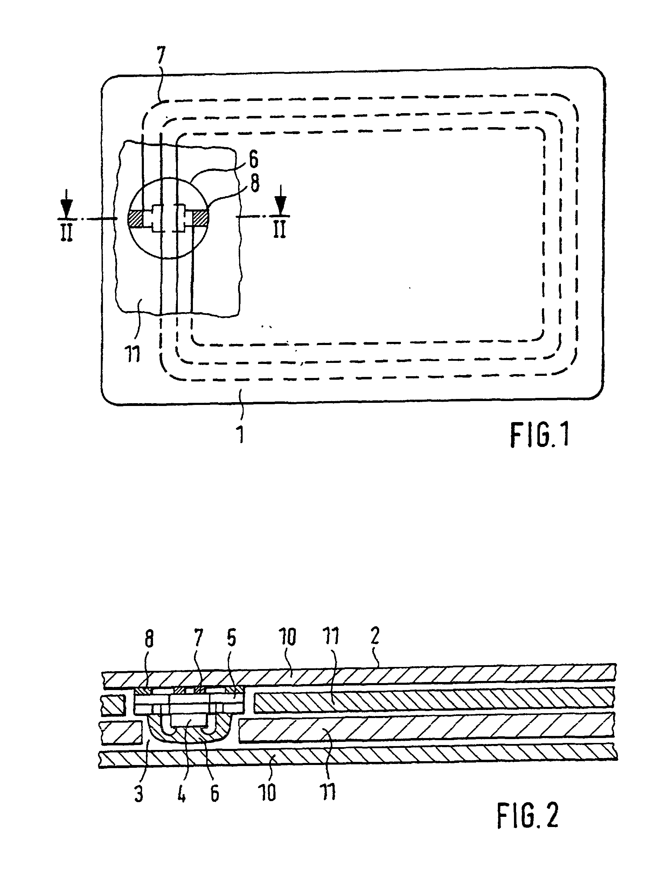

Fig. 1 zeigt ein Ausführungsbeispiel eines Datenträgers 1 umfassend einen Kartenkörper 2 mit einer unter der oberen Deckschicht angeordneten Spule 7, die elektrisch leitend mit einem Modul 6 verbunden ist.

Fig. 2 zeigt vergrößert und nicht maßstabsgetreu einen. Querschnitt entlang der in Fig. 1 strichliert eingezeichneten Linie innerhalb des Ausschnitts, der das Modul, einen Teil des Kartenkörpers und der Spule umfaßt. Das Modul 6 umfaßt wenigstens einen integrierten Schaltkreis 4 mit zwei Anschlüssen, die elektrisch leitend mit den Kontaktelementen 5 des Moduls verbunden sind. Das in Fig. 2 gezeigte Modul besteht z. B. aus einem Trägerfilm aus Kapton (TM), der auf einer Seite die Kontaktelemente 5 aufweist. Der Trägerfilm weist in bekannter Weise entsprechend positionierte Fenster zur Aufnahme des integrierten Schaltkreises und zur Hindurchführung der Leiterdrähte vom Schaltkreis zu den Kontaktelementen auf. Zum Schutz vor mechanischen Belastungen können der integrierte Schaltkreis und die Leiterdrähte mit einer Gußmasse vergossen werden. Bei dem hier gezeigten Ausführungsbeispiel eines Moduls sind die Kontaktelemente als elektrisch leitende Beschichtung auf dem Trägerfilm aufgebracht, die dann z. B. per wire-bonding mit den Anschlüssen des integrierten Schaltkreises verbunden werden.

Der in Fig. 2 gezeigte Datenträger wird z. B. in der dem Fachmann geläufigen Laminiertechnik hergestellt, wobei das zuvor separat hergestellte Modul ohne Spule in einen mehrschichtig aufgebauten Kartenkörper einlaminiert wird. Der mehrschichtige Kartenkörper 2 umfaßt jeweils eine obere und untere Deckschicht 10 sowie wenigstens eine innere Kartenschicht 11, die zur Aufnahme des Moduls eine entsprechende Öffnung 3 aufweist. Die Außenflächen der Deckschichten 10 sind in der Regel mit einem Aufdruck versehen. Auf einer der Innenflächen der Deckschichten 10, in diesem Ausführungsbeispiel der oberen Deckschicht, ist eine Spule 7 angeordnet, die mit der Kartenkörperschicht 10 ein Halbzeug bildet. Die Spulenanschlüsse 8 sind derart positioniert, daß sie den Kontaktelementen 5 des Moduls 6 direkt gegenüber angeordnet sind. Dies erlaubt eine einfache elektrisch leitende Verbindung der Kontaktelemente mit den Spulenanschlüssen. Die elektrisch leitende Verbindung kann z. B. mit Hilfe eines elektrisch leitenden Klebers erzielt werden. Die Spule 7 kann z. B. auf eine Kartenkörperschicht im Siebdruckverfahren mittels eines elektrisch leitenden Klebers aufgedruckt werden oder in Form einer elektrisch leitenden Beschichtung im Heißprägeverfahren auf die Kartenkörperschicht aufgebracht werden. Alternativ hierzu kann die Spule 7 auch aus einer Metallfolie oder einer elektrisch leitend beschichteten Kunststoffolie ausgestanzt und auf einer Schicht des Kartenkörpers angeordnet werden. Die Spule kann auch als drahtgewikkelte fertige Spule ohne Kern, z. B. mit Hilfe eines Klebers, auf der Kartenkörperschicht befestigt werden.

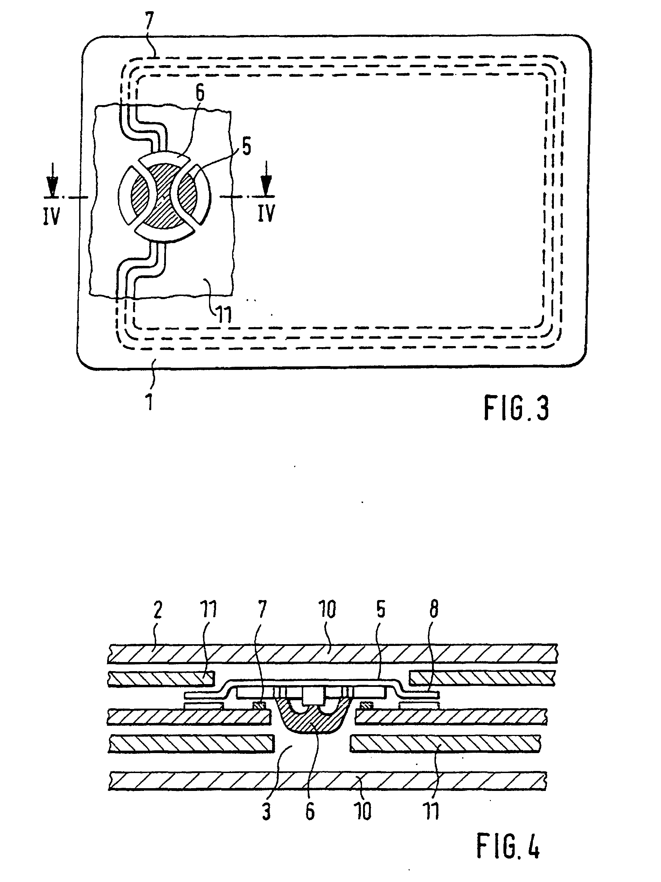

Fig. 3 und 4 zeigen ein weiteres Ausführungsbeispiel eines Datenträgers 1. Dieser unterscheidet sich von dem in Fig. 2 gezeigten im wesentlichen nur dadurch, daß die Spule 7 auf einer inneren Schicht 11 des Kartenkörpers 2 angeordnet ist. Diese innere Schicht des Kartenkörpers weist ebenfalls eine entsprechende Öffnung 3 zur Aufnahme des Moduls 6 auf. Die Kontaktelemente 5 des Moduls sind bei dieser Ausführungsform vorzugsweise gekröpft, dies erlaubt eine einfache Realisierung der elektrisch leitenden Verbindung mit den Anschlüssen 8 der Spule. Diese Ausführungsform hat den Vorteil, daß die inneren Schichten 11, die das Karteninlett des Datenträgers bilden, unabhängig vom Druckvorgang der Deckschichten 10 des Datenträgers zur Montage von Spule und Modul vorbereitet werden können. In den bisher beschriebenen Ausführungsbeispielen wurde der Datenträger vorzugsweise in der Laminiertechnik hergestellt. Selbstverständlich können auch andere Techniken, wie beispielsweise die Spritzgußtechnik oder die Montagetechnik, zum Einsatz kommen. Diese Techniken sind dem Fachmann geläufig und werden daher in den nachfolgenden Ausführungsbeispielen nur kurz erläutert.

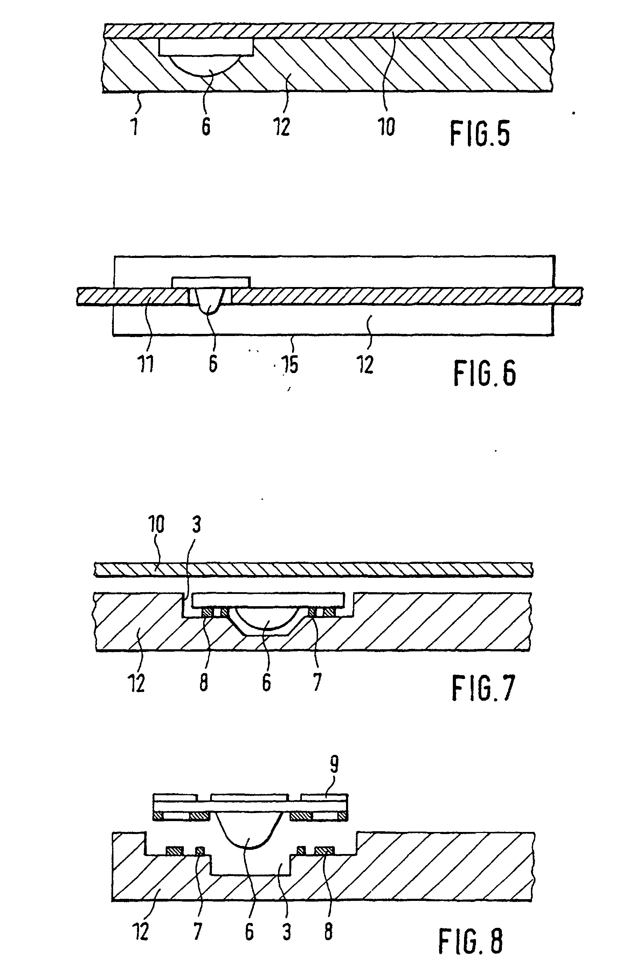

Fig. 5 zeigt stark schematisiert das bereits in Fig. 2 im Querschnitt dargestellte Halbzeug, welches die Kartenkörperschicht 10 mit darauf angeordneter Spule 7 umfaßt, deren Anschlüsse elektrisch leitend mit den Kontaktelementen des Moduls 6 elektrisch leitend verbunden sind. Dieses Halbzeug kann z. B. auch auf einen spritzgegossenen Kartenkörperteil 12, der mit einer entsprechenden Aussparung zur Aufnahme des Moduls versehen ist, montiert und mit dem Kartenkörperteil in bekannter Weise verbunden werden.

Fig. 6 zeigt stark schematisiert das bereits in Fig. 4 dargestellte Karteninlett 11 mit einem Modul 6 und einer Spule 7. Dieses separat hergestellte Halbzeug kann z. B. auch in der Spitzgußtechnik weiterverarbeitet werden. Dazu wird das Karteninlett mit Modul und Spule in bekannter Weise in eine Spritzgußform 15 eingeführt und mit einem Kunststoffmaterial umspritzt, das dann den Kartenkörperteil 12 bildet.

Fig. 7 zeigt schematisiert ein spritzgegossenes Kartenkörperteil 12 mit einer zweistufigen Aussparung 3, wobei auf den Schulterbereichen der Aussparung die Anschlüsse 8 der Spule 7 frei zugänglich angeordnet sind. Dadurch kann das Modul 6 beispielsweise in der bekannten Montagetechnik in einfacher Weise in die Aussparung 3 des Kartenkörperteils 12 eingebaut werden, wobei die elektrisch leitende Verbindung der Spulenanschlüsse mit den Kontaktelementen des Moduls einfach realisierbar ist. Anschließend kann beispielsweise mit Hilfe einer Klebeschicht eine bedruckte Deckschicht 10 mit dem spritzgegossenen Kartenkörperteil 12 verbunden werden.

Fig. 8 zeigt ein Hybridmodul 6, welches zusätzlich zu der Spule 7 äußere Kontaktflächen 9 aufweist, die der berührenden Energieversorgung und/oder dem Datenaustausch dienen. Das Hybridmodul 6 kann ebenfalls in einfacher Weise in der bekannten Montagetechnik in eine dafür vorgesehene Aussparung 3 des spritzgegossenen Kartenkörperteils 12 eingebaut werden. Zur Modulmontage kann beispielsweise eine Haftklebeschicht oder eine thermoaktivierbare Klebeschicht verwendet werden. Das in Fig. 7 gezeigte Aufbringen einer bedruckten Deckschicht kann hier entfallen, da das gewünschte Druckbild bereits beim Spritzgießen des Kartenkörpers mitberücksichtigt wird. In diesem Fall besteht der Kartenkörper dann nur noch aus einer Schicht.

## Patentansprüche

1. Datenträger (1), mit einem kartenförmigen Körper (2), bestehend aus einer oder mehreren Schichten, einem integrierten Schaltkreis (4) sowie wenigstens einer Spule (7), die der Energieversorgung und/oder dem Datenaustausch des integrierten Schaltkreises (4) mit externen Geräten dient, **dadurch gekennzeichnet, daß** ein Modul (6), welches den integrierten Schaltkreis (4) und wenigstens zwei Kontaktelemente (5) aufweist, über die genannten Kontaktelemente mit den Anschlüssen (8) der separat auf einer Schicht des Kartenkörpers (2) angeordneten Spule (7) elektrisch leitend verbunden ist,
wobei die Anschlüsse (8) der Spule (7) derart positioniert sind, daß sie den Kontaktelementen (5) des Moduls (6) direkt gegenüder angeordnet sind, so daß die Anschlüsse (8) und die Kontaktelement (5) in direkter Berührung stehen, un die elektrisch leitende Verbindung zwischen dem Modul (6) und der Spule (7) zu erzielen.

2. Datenträger nach Anspruch 1, **dadurch gekennzeichnet, daß** die Spule (7) auf einer Deckschicht (10) oder auf einer inneren Schicht (11) des Kartenkörpers (2) oder auf einem spritzgegossenen Kartenkörperteil (12) angeordnet ist.

3. Datenträger nach Anspruch 2, **dadurch gekennzeichnet, daß** die Spule (7) als Flachspule ausgebildet ist, die als fertige drahtgewickelte Spule auf einer isolierenden Schicht des Kartenkörpers aufgeklebt oder als elektrisch leitende Schicht auf einer isolierenden Schicht des Kartenkörpers aufgedruckt oder im Heißprägeverfahren in die Kartenkörperschicht geprägt ist oder aus einer Metallfolie oder einer elektrisch leitend beschichteten Kunststoffolie gestanzt und auf einer Schicht des Kartenkörpers angeordnet ist.

4. Datenträger nach Anspruch 2, **dadurch gekennzeichnet, daß** die Spule (7) sich im wesentlichen über die gesamte Fläche des Kartenkörpers (2) erstreckt.

5. Datenträger nach Anspruch 1, **dadurch gekennzeichnet, daß** die Anschlüsse (8) der Spule (7) elektrisch leitend mit den Kontaktelementen (5) des Moduls (6) verklebt sind.

6. Datenträger nach Anspruch 1, **dadurch gekennzeichnet, daß** das Modul (6) zusätzlich äußere Kontaktflächen (9) zur berührenden Energieversorgung und/oder zum Datenaustausch mit externen Geräten aufweist.

7. Verfahren zur Herstellung eines Datenträgers (1) mit einem ein- oder mehrschichtigen Kartenkörper (2) einem integrierten Schaltkreis (4) sowie wenigstens einer Spule (7), die der Energieversorgung und/oder dem Datenaustausch des integrierten Schaltkreises (4) mit externen Geräten dient, **dadurch gekennzeichnet, daß** ein Modul (6) hergestellt wird, das den integrierten Schaltkreis (4) und wenigstens zwei Kontaktelemente (5) aufweist und daß separat von der Herstellung des Moduls (6) auf einer Schicht des Kartenkörpers (2) die Spule (7) aufgebracht wird und daß die genannten Kontaktelemente (5) des Moduls (6) derart positioniert werden, daß sie den Anschlüssen (8) der Spule (7) direkt gegenüber angeordnet werden, so daß die Anschlüsse (8) und die (5) Kontaktelemente in direkte Beichung stehen, um die elektrisch leitende Verbindung zwischen dem Modul (6) und der Spule (7) zu eizielem.

8. Verfahren nach Anspruch 7, **dadurch gekennzeichnet, daß** die Spule auf eine Kartenkörperschicht im Siebdruckverfahren mittels eines elektrisch leitenden Klebers aufgedruckt oder die Spule aus einer Metallfolie oder einer elektrisch leitend beschichteten Kunststoffolie ausgestanzt und auf die Kartenkörperschicht aufgeklebt wird oder die Spule als elektrisch leitende Schicht im Heißprägeverfahren in die Kartenkörperschicht geprägt wird oder als drahtgewickelte Spule auf die Kartenkörperschicht aufgebracht wird.

9. Verfahren nach Anspruch 7, **dadurch gekennzeichnet, daß** die Anschlüsse der Spule mit den Kontaktelementen des Moduls elektrisch leitend verklebt werden.

## Claims

1. A data carrier (1) having a card-shaped body (2) comprising one or more layers, an integrated circuit (4) and at least one coil (7) serving the purpose of power supply and/or data exchange of the integrated circuit (4) with external devices, **characterized in that** a module (6) bearing the integrated circuit (4) and at least two contact elements (5) is electrically connected via said contact elements with the leads (8) of the coil (7) disposed separately on a layer of the card body (2), the leads (8) of the coil (7) being positioned so as to be disposed directly opposite the contact elements (5) of the module (6) so that the leads (8) and the contact elements (5) are in direct contact to obtain the electroconductive connection between the module (6) and the coil (7).

2. The data carrier of claim 1, **characterized in that** the coil (7) is disposed on a cover layer (10) or on an inner layer (11) of the card body (2) or on an injection molded card body part (12).

3. The data carrier of claim 2, **characterized in that** the coil (7) is formed as a flat coil which is glued to an insulating layer of the card body as a finished wire-wrapped coil, or printed on an insulating layer of the card body as an electroconductive layer, or stamped in the card body layer by the hot stamping method, or punched out of a metal foil or an electroconductively coated plastic film and disposed on a layer of the card body.

4. The data carrier of claim 2, **characterized in that** the coil (7) extends substantially over the entire surface of the card body (2).

5. The data carrier of claim 1, **characterized in that** the leads (8) of the coil (7) are glued electroconductively to the contact elements (5) of the module (6).

6. The data carrier of claim 1, **characterized in that** the module (6) additionally has outer contact surfaces (9) for contact-type power supply and/or for data exchange with external devices.

7. A method for producing a data carrier (1) having a one- or multilayer card body (2), an integrated circuit (4) and at least one coil (7) serving the purpose of power supply and/or data exchange of the integrated circuit (4) with external devices, **characterized in that** a module (6) is produced that bears the integrated circuit (4) and at least two contact elements (5), and the coil (7) is applied to a layer of the card body (2) separately from the production of the module (6), and said contact elements (5) of the module (6) are positioned so as to be disposed directly opposite the leads (8) of the coil (7) so that the leads (8) and the contact elements (5) are in direct contact to obtain the electroconductive connection between the module (6) and the coil (7).

8. The method of claim 7, **characterized in that** the coil is printed on a card body layer by the screen printing method by means of an electroconductive adhesive, or the coil is punched out of a metal foil or an electroconductively coated plastic film and glued to the card body layer, or the coil is stamped in the card body layer in the form of an electroconductive layer by the hot stamping method, or applied to the card body layer as a wire-wrapped coil.

9. The method of claim 7, **characterized in that** the leads of the coil are glued electroconductively to the contact elements of the module.

## Revendications

1. Support de données avec un corps en forme de carte (2), composé de une ou de plusieurs couches, un circuit intégré (4) ainsi qu'au moins une bobine (7) qui sert à l'alimentation en énergie et/ou l'échange de données du circuit intégré (4) avec des appareils externes,
**caractérisé en ce que**
un module (6) présentant au moins le circuit intégré (4) et au moins deux éléments de contact (5) est relié, grâce auxdits éléments de contact (5), de façon électriquement conductrices, avec les bornes (8) de la bobine (7) agencée séparément sur une couche du corps de carte (2), dans lequel les bornes (8) de la bobine (7) sont positionnés de manière à être agencés directement en face des éléments de contact (5) du module (6) de sorte que les bornes (8) et les éléments de contact (5) se trouvent directement en contact afin de réaliser la liaison électriquement conductrice entre le module (6) et la bobine (7).

2. Support de données selon la revendication 1, **caractérisé en ce que** la bobine (7) est agencée sur une couche de couverture (10) ou sur une couche interne (11) du corps de carte (2) ou sur une partie du corps de carte, moulé par injection (12).

3. Support de données selon la revendication 2, **caractérisé en ce que** la bobine (7) est réalisée sous forme d'une bobine plate qui est collée sous forme d'une bobine à enroulement filaire préparé à l'avance sur une couche isolante du corps de la carte ou est obtenu par impression sous forme d'une couche électriquement conductrice sur une couche isolante du corps de la carte ou est obtenu par gaufrage par un procédé d'estampage à chaud dans la couche du corps de la carte ou est estampé dans une feuille métallique ou une feuille de matière plastique avec un revêtement électriquement conducteur pour être agencé sur une couche du corps de la carte.

4. Support de données selon la revendication 2, **caractérisé en ce que** la bobine (7) s'étend essentiellement sur toute la surface du corps de carte (2).

5. Support de données selon la revendication 1 **caractérisé en ce que** les bornes (8) de la bobine (7) sont collées de façon électriquement conductrice aux éléments de contact (5) du module (6).

6. Support de données selon la revendication 1 **caractérisé en ce que** le module (6) présente, en plus, des surfaces de contact externe (9) pour une alimentation en énergie et/ou échange de données par contact, avec des appareils externes.

7. Procédé de réalisation d'un support de données 1 avec un corps de carte (2) à une seule ou plusieurs couches, un circuit intégré (4) ainsi qu'au moins une bobine (7) servant à l'alimentation en énergie et/ou l'échange de données du circuit intégré (4) avec des appareils externes, **caractérisé en ce qu'**on fabrique un module (6) présentant le circuit intégré (4) et au moins deux éléments de contact (5) et **en ce que**, indépendamment de la fabrication du module (6), on applique sur une couche du corps de carte (2) la bobine (7) et **en ce que** lesdits éléments de contact (5) du module (6) sont positionnés de sorte à se trouver directement en face des bornes (8) de la bobine (7), de sorte que les bornes (8) et les éléments de contact (5) se trouvent en contact direct, afin de réaliser le raccordement électriquement conducteur entre le module (6) et la bobine (7).

8. Procédé selon la revendication 7, **caractérisé en ce que** la bobine est imprimée sur une couche du corps de la carte par sérigraphie au moyen d'une colle électriquement conductrice ou la bobine est découpée dans une feuille métallique ou une feuille en matière plastique portant un revêtement électriquement conducteur, pour être collée sur la couche du corps de la carte, ou la bobine est obtenue par gaufrage sous forme d'une couche électriquement conductrice par estampage à chaud dans la couche du corps de la carte, ou alors la bobine est appliquée sous forme d'enroulement filaire sur la couche du corps de la carte.

9. Procédé selon la revendication 7 **caractérisé en ce que** les bornes de la bobine sont collées de façon électriquement conductrice aux éléments de contact du module.
